(19) Europäisches Patentamt
European Patent Office
Office européen des brevets

(11) Veröffentlichungsnummer: **0 424 737 A2**

# (12) EUROPÄISCHE PATENTANMELDUNG

(21) Anmeldenummer: **90119474.6**

(51) Int. Cl.5: **G03F 7/004**

(22) Anmeldetag: **11.10.90**

(30) Priorität: **25.10.89 DE 3935451**

(43) Veröffentlichungstag der Anmeldung:
**02.05.91 Patentblatt 91/18**

(84) Benannte Vertragsstaaten:
**BE CH DE FR GB IT LI NL SE**

(71) Anmelder: **BASF Aktiengesellschaft**
**Carl-Bosch-Strasse 38**
**W-6700 Ludwigshafen(DE)**

(72) Erfinder: **Nguyen, Kim Son, Dr.**
**Zedernweg 9**
**W-6944 Hemsbach(DE)**

## (54) Strahlungsempfindliches Gemisch und Verfahren zur Herstellung von Reliefmustern.

(57) Strahlungsempfindliches Gemisch, im wesentlichen bestehend aus
(a) einem in Wasser unlöslichen, in wäßrig-alkalischen Lösungen löslichen Bindemittel oder Bindemittelgemisch, und
(b) einer bei Bestrahlung eine starke Säure bildenden Verbindung, wobei als Bindemittel (a) ein phenolisches Harz eingesetzt wird, dessen phenolische Hydroxylgruppen zu 5 bis 50 % dieser Gruppen durch $\beta$-halogenierte Alkylcarbonatgruppen ersetzt sind.
Dieses strahlungsempfindliche Gemisch eignet sich zur Herstellung von Reliefstrukturen.

EP 0 424 737 A2

## STRAHLUNGSEMPFINDLICHES GEMISCH UND VERFAHREN ZUR HERSTELLUNG VON RELIEFMUSTERN

Die Erfindung betrifft positiv arbeitende strahlungsempfindliche Gemische, die ein wäßrig-alkalisch lösliches Bindemittel, welches hydrophobe Comonomereinheiten einpolymerisiert enthält, und eine Verbindung, die unter Einwirkung von Strahlung eine starke Säure bildet, wobei die Löslichkeit der Verbindung in einem alkalischen Lösungsmittel durch die Einwirkung der Säure erhöht wird, enthalten. Diese Gemische sind sensitiv gegenüber UV-, Elektronen- und Röntgenstrahlen und eignen sich besonders als Resistmaterialien und zur Herstellung von Reliefmustern.

Positiv arbeitende strahlungsempfindliche Gemische sind bekannt. Besonders positiv arbeitende Resistmaterialien, die o-Chinondiazide in wäßrig-alkalisch löslich Bindemitteln, z.B. Novolaken enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslösen, sind ebenfalls beschrieben. In der US-A- 3 932 514 und der US-A-3 915 706 werden beispielsweise Photoinitiatoren beschrieben, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer, sowie eine Verbindung die photochemisch eine starke Säure bildet und eine weitere Verbindung mit durch Säure spaltbaren Bindungen, die durch die Einwirkung der Säure ihre Löslichkeit in einem alkalischen Entwickler erhöhen, enthalten (vgl. z.B. DE-A-3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A- 4 491 628 bekannt. Einen Überblick über die Anwendung von Oniumsalzen in Resistmaterialien gibt Crivello in Org. Coatings and Appl. Polym. Sci., 48, S. 65-69 (1985). Strahlungsempfindliche Gemische von Polymeren mit säurelabilen Seitengruppen und photochemischen Säurespendern sind z.B. aus US-A-4 491 628, FR-A-2 570 844 und Polymeric Material Science and Engineering, A.C.S., Vol. 61, 417-421 (1989) bekannt. Diese polymeren Bindemittel sind jedoch hydrophob und werden erst nach der Belichtung alkalilöslich.

Copolymere mit phenolischen und säurelabilen Gruppen, wie z.B. Poly-(p-hydroxistyrol-co-tert.-butoxicarbonyloxistyrol) sind aus J. Poly. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit kommerziellen Sulfoniumsalzen, wie Triphenylsulfoniumhexafluoroarsenat, wie auch in US-A-4 491 628 beschrieben, so weisen diese Gemische den Nachteil auf, daß beim Entwickeln ein sehr hoher Abtrag der unbelichteten Bereiche stattfindet, da diese Sulfoniumsalze nicht genügend zur Löslichkeitsinhibierung beitragen. Ähnliche Ergebnisse erhält man, wenn man im obengenannten Copolymeren die tert.-Butoxicarbonyloxistyroleinheiten durch tert.-Amyloxicarbonyloxistyroleinheiten ersetzt.

In der DE-A-37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Für bestimmte Anwendungszwecke haben diese Systeme jedoch Nachteile.

Aufgabe der vorliegenden Erfindung ist es, hochaktive strahlungsempfindliche Systeme für die Herstellung von Reliefstrukturen zur Verfügung zu stellen, die sich mit wäßrig-alkalischen Lösungen entwickeln lassen und die die Herstellung von lichtempfindlichen Schichten mit hoher Transparenz im kurzwelligen UV ermöglichen.

Überraschenderweise kann diese Aufgabe durch die Verwendung von phenolischen Harzen, deren phenolische Hydroxylgruppen teilweise durch $\beta$-halogenierte Alkylcarbonatgruppen ersetzt sind, gelöst werden.

Gegenstand der vorliegenden Erfindung ist ein strahlungsempfindliches Gemisch, im wesentlichen bestehend aus

a) einem in Wasser unlöslichen, in wäßrig-alkalischen Lösungen löslichen Bindemittel oder Bindemittelgemisch, und

b) einer bei Bestrahlung eine starke Säure bildenden Verbindung, das dadurch gekennzeichnet ist, daß als Bindemittel (a) ein phenolisches Harz eingesetzt wird, dessen phenolische Hydroxylgruppen zu 5 bis 50 % dieser Gruppen durch $\beta$-halogenierte Alkylcarbonatgruppen ersetzt sind.

Als phenolische Harze kommen dabei Novolake mit mittleren Molekulargewichten $\overline{M}_w$ zwischen 300 und 20 000, deren phenolische Hydroxylgruppen zu 5 bis 50 % dieser Gruppen durch $\beta$-halogenierte Alkylcarbonatgruppen ersetzt sind, sowie Poly-(p-hydroxistyrol) oder Poly-(p-hydroxi-$\alpha$-methylstyrol) mit mittleren Molekulargewichten $\overline{M}_w$ zwischen 200 und 100 000, deren phenolische Hydroxylgruppen zu 5 bis 50 % dieser Gruppen durch $\beta$-halogenierte Alkylcarbonatgruppen ersetzt sind, oder Gemische der genannten phenolischen Harze, in Frage.

Die $\beta$-halogenierten Alkylcarbonatgruppen entsprechen vorzugsweise der allgemeinen Formel (I)

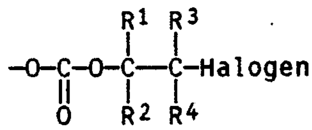

(I)

worin Halogen für Chlor oder Brom, vorzugsweise Chlor steht und
$R^1$ und $R^2$ untereinander gleich oder verschieden sind und für Wasserstoff oder Methyl stehen, sowie
$R^3$ und $R^4$ untereinander gleich oder verschieden sind und für Wasserstoff oder Chlor stehen.

Als bei Bestrahlung eine starke Säure bildende Verbindung (b) enthalten die erfindungsgemäßen strahlungsempfindlichen Gemische vorzugsweise mindestens ein Sulfoniumsalz der allgemeinen Formel (II)

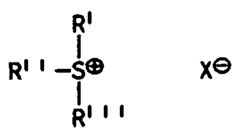

(II),

worin $R'$, $R''$ und $R'''$ untereinander gleich oder verschieden sind und für Alkyl mit 1 bis 3 Kohlenstoffatomen, Aryl, substituiertes Aryl oder Aralkyl stehen, und $X^{\ominus}$ = $AsF_6^{\ominus}$, $SbF_6^{\ominus}$, $PF_6^{\ominus}$, $BF_4^{\ominus}$ und/oder $CF_3SO_3^{\ominus}$ ist. Besonders bevorzugt sind auch solche Sulfoniumsalze der allgemeinen Formel (II), worin mindestens einer der Reste $R'$, $R''$ und $R'''$ den Rest

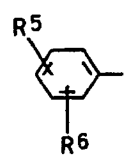

bedeutet, worin $R^5$ und $R^6$ untereinander gleich oder verschieden sind und für H, OH, Alkyl mit 1 bis 3 Kohlenstoffatomen, oder einen der Reste

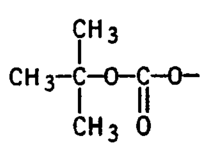

oder

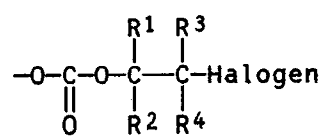

stehen, worin Halogen für Chlor oder Brom steht, $R^1$ und $R^2$ untereinander gleich oder verschieden sind und für Wasserstoff oder Methyl stehen, sowie $R^3$ und $R^4$ untereinander gleich oder verschieden sind und für Wasserstoff oder Chlor stehen.

Die erfindungsgemäßen strahlungsempfindlichen Gemische enthalten im allgemeinen 70 bis 98, vorzugsweise 85 bis 97 Gew.-% der Komponente (a) und 2 bis 30, vorzugsweise 3 bis 15 Gew.-% der Komponente (b).

Die erfindungsgemäßen strahlungsempfindlichen Gemische können zusätzlich polycyclische aromatische Verbindungen, wie z.B. Perylen oder Pyren, als Sensibilisatoren enthalten, die Strahlung absorbieren und auf die säurebildende Verbindung (b) übertragen.

Gegenstand der vorliegenden Erfindung ist außerdem ein Verfahren zur Herstellung von Reliefstrukturen oder Reliefmustern durch Auftragen von Photoresistlösungen in einer Schichtdicke von 0,1 bis 5 $\mu$m auf ein in üblicher Weise vorbehandeltes Substrat, Trocknen, bildmäßige Bestrahlung, Erhitzen auf Temperaturen

von 50 zu 150° C und Entwickeln mit einer wäßrig-alkalischen Lösung, wobei Photoresistlösungen eingesetzt werden, die erfindungsgemäße strahlungsempfindliche Gemische enthalten.

Die erfindungsgemäßen strahlungsempfindlichen Gemische sind hochaktive Systeme, die sich sehr vorteilhaft für die Herstellung von im kurzwelligen UV strahlungsempfindlichen Schichten, insbesondere für Reliefmuster verwenden lassen.

Zu den strahlungsempfindlichen Gemischen, ihren Aufbaukomponenten und ihrer Verwendung ist im einzelnen folgendes auszuführen.

(a) Als in Wasser unlösliche, in wäßrig-alkalischen Lösungen lösliche Bindemittel kommen in Frage phenolische Harze, wie z.B. Novolake mit mittleren Molekulargewichten $\overline{M}_w$ zwischen 300 und 20 000, vorzugsweise zwischen 500 und 5000, beispielsweise Novolake auf Basis von p-Kresol/Formaldehyd, insbesondere Poly-(p-hydroxistyrole), Poly-(p-hydroxi-α-methylstyrole), beispielsweise mit mittleren Molekulargewichten $\overline{M}_w$ zwischen 200 und 100 000, vorzugsweise 5000 bis 40 000, soweit diese phenolischen Harze seitenstände β-halogenierte Alkylcarbonatgruppen enthalten, sowie Gemische derartiger phenolischer Harze.

Die erfindungsgemäß einzusetzenden Polymeren auf Basis von p-Hydroxistyrolen können durch polymeranaloge Umsetzung von z.B. Poly-(p-Hydroxistyrol) mit den entsprechenden stöchiometrischen Mengen β-halogenierte Alkylgruppen enthaltenden Pyrokohlensäureester, Chlorkohlensäureester oder Imidazol-N-carbonsäureester hergestellt werden.

Zur Einführung der β-halogenierten Alkylcarbonatgruppen kann beispielsweise Poly-(p-hydroxystyrol) mit der entsprechenden stöchiometrischen Menge Chlorkohlensäurealkylester umgesetzt werden, wobei Poly-(p-hydroxystyrol) mit NaOH-Lösung versetzt wird und anschließend beispielsweise Chlorameisensäure-2,2,2-trichlorethylester zugetropft wird. Das erfindungsgemäße Polymer kann durch Fällen in Ligroin gewonnen und durch Extraktion mit Methylenchlorid gereinigt werden.

Als Ausgangsprodukte zur Herstellung von Novolaken mit β-halogenierten Alkylcarbonatgruppen kommen beispielsweise solche Novolake in Frage, wie sie in Novolak Resins Used in Positive Resist Systems von T. Pampalone in Solid State Technology, June 1984, Seite 115 bis 120, beschrieben sind. Für spezielle Anwendungen, z.B. für Belichtung im kurzwelligen UV-Gebiet kommen bevorzugt Novolake aus p-Kresol und Formaldehyd in Frage.

Beispiele für geeignete β-halogenierte Alkylcarbonatgruppen enthaltende phenolische Harze (a) lassen sich auch durch folgendes Formelschema wiedergeben:

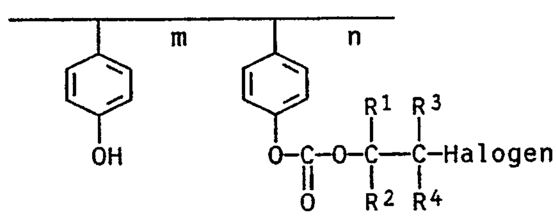

wobei m ≧ n
und Halogen sowie $R^1$ bis $R^4$ die oben bereits angegebene Bedeutung haben.

Erfindungsgemäß sind 5 bis 50 %, vorzugsweise 10 bis 40 % der phenolischen Hydroxylgruppen des phenolischen Harzes durch β-halogenierte Alkylcarbonatgruppen ersetzt.

Das erfindungsgemäß zu verwendende Bindemittel (a) läßt sich besonders vorteilhaft als Bindemittel für Photoresiste einsetzen, da sie gute Oberflächenqualität, sehr geringen Abtrag in den unbelichteten Bereichen und eine Entwicklung ohne Quellung ermöglichen.

Als Säurespender (b) eignen sich alle Verbindungen, welche unter Bestrahlung eine starke Säure bilden. Bevorzugt zur kurzwelligen Bestrahlung sind jedoch Sulfoniumsalze der allgemeinen Formel (II)

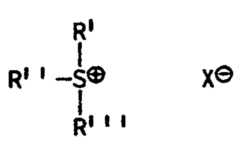 (II),

worin R′, R″ und R‴ untereinander gleich oder verschieden sind und für Alkyl mit 1 bis 3 Kohlenstoffatomen wie z.B. Methyl, Ethyl, Aryl, wie z.B Phenyl, substituiertes Aryl, wie z.B. substituiertes Phenyl, oder Aralkyl, wie z.B. Benzyl, stehen, und $X^{\ominus}$ = $AsF_6^{\ominus}$, $SbF_6^{\ominus}$, $PF_6^{\ominus}$, $ClO_4^{\ominus}$, $BF_4^{\ominus}$ und/oder $CF_3SO_3^{\ominus}$ (= Triflat).

Von diesen Sulfoniumsalzen bevorzugt sind solche der allgemeinen Formel (II), in denen mindestens einer der Reste R′, R″ und R‴ den Rest

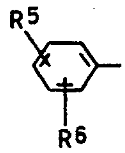

bedeutet, worin $R^5$ und $R^6$ untereinander gleich oder verschieden sind und für H, OH, Alkyl mit 1 bis 3 Kohlenstoffatomen, wie z.B. Methyl, Ethyl, oder einen der Reste

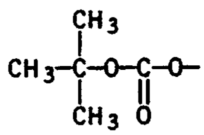

oder

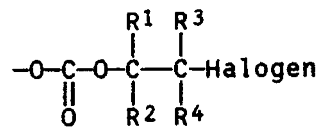

stehen, worin Halogen für Chlor oder Brom steht, $R^1$ und $R^2$ untereinander gleich oder verschieden sind und für Wasserstoff oder Methyl stehen, sowie $R^3$ und $R^4$ untereinander gleich oder verschieden sind und für Wasserstoff oder Chlor stehen.

Beispiele für geeignete Sulfoniumsalze sind Triphenylsulfoniumhexafluoroarsenat oder -phosphat und Dimethyl-4-hydroxiphenylsulfoniumtriflat oder -hexafluoroarsenat.

Auch andere Säurespender können als Komponente (b) eingesetzt werden, beispielsweise Jodoniumverbindung:

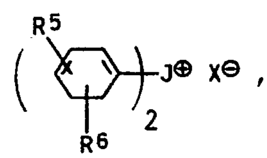

worin $R^5$, $R^6$ und $X^{\ominus}$ die oben angegebene Bedeutung haben.

Die erfindungsgemäßen Gemische werden bevorzugt in einem organischen Lösungsmittel gelöst, wobei der Feststoffgehalt im Bereich im allgemeinen zwischen 5 und 40 Gew.-% liegt. Als Lösungsmittel kommen bevorzugt aliphatische Ketone, Ether, sowie Mischungen derselben in Frage, besonders Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone wie beispielsweise Cyclohexanon, Cyclopentanon und Methyl-ethyl-keton sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler , Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Vorzugsweise werden z.B. das polymere Bindemittel (a), welches zwischen 10 und 40 Mol-% Monomerkomponente mit säurelabilen Gruppen enthält, und zwischen 2 bis 30 Gew.-%, besonders bevorzugt zwischen 5 und 15 Gew.-% einer Verbindung des Typs (b), bezogen auf das Gesamtgewicht der Verbindungen (a) und (b), in einem Lösungsmittel wie z.B. Methylglykolacetat oder Methyl-propylenglykolacetat gelöst, wobei der Feststoffgehalt zwischen 10 und 30 Gew.-% beträgt.

Die Lösung des erfindungsgemäßen strahlungsempfindlichen Gemisches kann durch ein Filter mit einem Porendurchmesser von 0,2 µm filtriert werden.

Durch Aufschleudern der Resistlösung bei Umdrehungszahlen zwischen 1000 und 10 000 U/min wird

ein Resistfilm einer Schichtdicke von 0,1 bis 5 µm auf einem Wafer (z.B. ein an der Oberfläche oxidierter Silicium-Wafer) erzeugt. Der Wafer wird dann zwischen 1 und 5 Minuten bei 90° C bzw. 80° C ausgeheizt.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60° C und 120° C in wäßrig-alkalischen Lösungsmitteln zunimmt und diese Bereiche selektiv mit dem alkalischen Entwickler entfernt werden können.

Die Resist-Filme werden z.B. durch eine chrombeschichtete strukturierte Quarzmaske mit UV-Licht einer Quecksilberlampe, mit Excimer-Laserlicht, Elektronen-oder Röntgenstrahlen bestrahlt. Die bildmäßig bestrahlten Filme können dann z.B. zwischen 5 Sekunden und 2 Minuten bei Temperaturen zwischen 60° C und 110° C ausgeheizt und hierauf mit wäßrig-alkalischen Entwicklern entwickelt werden, wobei sich die belichteten Bereiche selektiv ablösen, während in den unbelichteten Bereichen nur wenig Abtrag stattfindet.

Die in den folgenden Beispielen angegebenen Teile und Prozente sind, soweit nicht anders angegebenen, Gewichtsteile bzw. Gewichtsprozente.

Beispiel 1

Synthese von Poly-(p-hydroxistyrol-co-halogenethyloxi-carbonyloxistyrol)

Poly-(p-hydroxistyrol-co- 20 Mol-% Chlorethyloxi-carbonyloxistyrol) wird wie folgt hergestellt:

5 g Poly-(p-hydroxistyrol) (= kommerz. Produkt der Fa. Polysciences Inc., $\overline{M}_w$ = 1500 bis 7000 g/mol) werden in Natronlauge (4 g NaOH und 20 g $H_2O$) gelöst. Danach wird 1 g Chlorameisensäure-2-chlorethylester bei Raumtemperatur zugetropft. Die Temperatur steigt um etwa 5° C. Die Reaktionszeit beträgt 30 Minuten. Danach wird das Gemisch mit 20 ml $H_2O$ und 10 ml Aceton verdünnt und mit verdünnter HCl neutralisiert (pH 5). Das so erhaltene Produkt wird mit 100 ml Tetrahydrofuran extrahiert, abgetrennt und fast bis zur Trockene eingedampft. Der Rückstand wird in etwa 30 ml Essigester gelöst und über $Na_2SO_4$ getrocknet. Das Bindemittel wird dann in 800 ml Ligroin ausgefällt und abgesaugt. Das Rohprodukt wird schließlich durch Extraktion mit Methylenchlorid gereinigt.

Eine Photoresistlösung wird aus 95 Teilen Poly-(p-hydroxystyrol-co-20 Mol-% Chlorethlyoxi-carbonyloxistyrol), 5 Teilen Triphenylsulfonium-hexafluoroarsenat (= Handelsprodukt der Firma Alfa) und 300 Teilen Ethylglykolacetat hergestellt. Die Lösung wird anschließend durch ein Filter mit einem Porendurchmesser von 0,2 µm filtriert.

Die Resistlösung wird auf einem oxidierten Siliciumwafer in 1 µm Schichtdicke aufgeschleudert. Der so beschichtete Wafer wird 4 Minuten bei 80° C getrocknet und anschließend mit einer bildmäßig strukturierten Testmaske im Kontaktverfahren 5 Sekunden mit Excimerlaserlicht der Wellenlänge $\lambda$ = 248 nm belichtet. Danach wird 60 Sekunden bei 80° C ausgeheizt und mit einem Entwickler von pH-Wert 12,1 bis 13,4 etwa 60 Sekunden entwickelt.

Beispiel 2

Eine Photoresistlösung wird aus 90 Teilen Poly-(p-hydroxistyrol-co-20 Mol-% Chlorethyloxi-carbonyloxistyrol), 10 Teilen Triphenylsulfonium-hexafluorophosphat und 300 Teilen Ethylglykolacetat hergestellt. Es wird wie in Beispiel 1 verfahren. Die Empfindlichkeit für 1 µm Schichtdicke beträgt 280 mJ/cm$^2$.

Beispiel 3

Eine Photoresistlösung wird aus 95 Teilen Poly-(p-hydroxistyrol-co-30 Mol-% Trichlorethyloxi-carbonyloxistyrol), 5 Teilen Triphenylsulfonium-hexafluoroarsenat und 300 Teilen Ethylglykolacetat hergestellt. ES wird wie in Beispiel 1 verfahren. Die Empfindlichkeit für 1 µm Schichtdicke beträgt 150 mJ/cm$^2$.

Beispiel 4

Eine Photoresistlösung wird aus 95 Teilen Poly(p-hydroxistyrol-co-20 Mol-% Trichlorethyloxi-carbonyloxistyrol), 5 Teilen Dimethyl-4-hydroxyphenyl-sulfoniumtriflat und 300 Teilen Ethylglykolacetat hergestellt. Es wird wie in Beispiel 1 verfahren. Die Empfindlichkeit für 1 µm Schichtdicke beträgt 400 mJ/cm².

## Ansprüche

1. Strahlungsempfindliches Gemisch, im wesentlichen bestehend aus
(a) einem in Wasser unlöslichen, in wäßrig-alkalischen Lösungen löslichen Bindemittel oder Bindemittelgemisch, und
(b) einer bei Bestrahlung eine starke Säure bildenden Verbindung,
dadurch gekennzeichnet, daß als Bindemittel (a) ein phenolisches Harz eingesetzt wird, dessen phenolische Hydroxylgruppen zu 5 bis 50 % dieser Gruppen durch β-halogenierte Alkylcarbonatgruppen ersetzt sind.
2. Strahlungsempfindliches Gemisch nach Anspruch 1, dadurch gekennzeichnet, daß das phenolische Harz ein Novolak mit einem mittleren Molekulargewicht $\overline{M}_w$ zwischen 300 und 20 000 ist, dessen phenolische Hydroxylgruppen zu 5 bis 50 % dieser Gruppen durch β-halogenierte Alkylcarbonatgruppen ersetzt sind.
3. Strahlungsempfindliches Gemisch nach Anspruch 1, dadurch gekennzeichnet, daß das phenolische Harz ein Poly-(p-hydroxistyrol) oder Poly-(p-hydroxi-α-methylstyrol) mit mittleren Molekulargewichten $\overline{M}_w$ zwischen 200 und 100 000 ist, deren phenolische Hydroxylgruppen zu 5 bis 50 % dieser Gruppen durch β-halogenierte Alkylcarbonatgruppen ersetzt sind.
4. Strahlungsempfindliches Gemisch nach einem der vorhergehenden Ansprüche, dadurch gekennzeichnet, daß die β-halogenierte Alkylcarbonatgruppe der allgemeinen Formel (I)

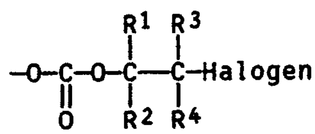

(I)

entspricht, worin Halogen für Chlor oder Brom steht und
$R^1$ und $R^2$ untereinander gleich oder verschieden sind und für Wasserstoff oder Methyl stehen, sowie
$R^3$ und $R^4$ untereinander gleich oder verschieden sind und für Wasserstoff oder Chlor stehen.
5. Strahlungsempfindliches Gemisch nach einem der vorhergehenden Ansprüche, dadurch gekennzeichnet, daß als bei Bestrahlung eine starke Säure bildende Verbindung (b) ein Sulfoniumsalz der allgemeinen Formel (II)

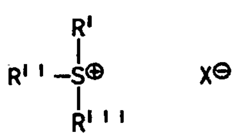

(II),

eingesetzt wird, worin R′, R″ und R‴ untereinander gleich oder verschieden sind und für Alkyl mit 1 bis 3 Kohlenstoffatomen, Aryl, substituiertes Aryl oder Aralkyl stehen, und $X^{\ominus}$ = $AsF_6^{\ominus}$, $SbF_6^{\ominus}$, $PF_6^{\ominus}$, $ClO_4^{\ominus}$, $BF_4^{\ominus}$ und/oder $CF_3SO_3^{\ominus}$ ist.
6. Strahlungsempfindliches Gemisch nach Anspruch 5, dadurch gekennzeichnet, daß im Sulfoniumsalz der allgemeinen Formel (II) mindestens einer der Reste R′, R″, und R‴ den Rest

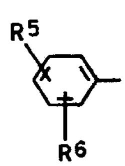

bedeutet, worin $R^5$ und $R^6$ untereinander gleich oder verschieden sind und für H, OH, Alkyl mit 1 bis 3 Kohlenstoffatomen oder einen der Reste

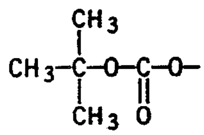 oder 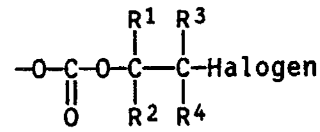

stehen, worin Halogen für Chlor oder Brom steht, $R^1$ und $R^2$ untereinander gleich oder verschieden sind und für Wasserstoff oder Methyl stehen, sowie $R^3$ und $R^4$ untereinander gleich oder verschieden sind und für Wasserstoff oder Chlor stehen.

7. Strahlungsempfindliches Gemisch nach einem der vorhergehenden Ansprüche, dadurch gekennzeichnet, daß es 70 bis 98 Gew.-% der Komponente (a) und 2 bis 30 Gew.-% der Komponente (b) enthält.

8. Strahlungsempfindliches Gemisch nach einem der vorhergehenden Ansprüche, dadurch gekennzeichnet, daß das Gemisch zusätzlich als Sensibilisator eine polycyclische aromatische Verbindung enthält, die Strahlung absorbiert und auf die säurebildende Verbindung (b) überträgt.

9. Verfahren zur Herstellung von Reliefstrukturen oder Reliefmustern durch Auftragen von Photoresistlösungen in einer Schichtdicke von 0,1 bis 5 µm auf ein in üblicher Weise vorbehandeltes Substrat, Trocknen, bildmäßige Bestrahlung, Erhitzen auf Temperaturen von 50 zu 150 °C und Entwickeln mit einer wäßrigalkalischen Lösung, dadurch gekennzeichnet, daß Photoresistlösungen eingesetzt werden, die strahlungsempfindliche Gemische nach einem der vorhergehenden Ansprüche enthalten.